# EUROPEAN PATENT APPLICATION

(11) **EP 4 768 966 A1**
(43) Date of publication of application: **01.07.2026**
(21) Application number: 25866355.8
(22) Date of filing: 06.08.2025
(51) Int. Cl.: G01R 31/392, G01R 31/382, G01R 31/396, H01M 10/48, H01M 10/42, H01M 4/58, H01M 4/525, H01M 4/505, H01M 4/38, H01M 4/587

(54) **BATTERY DIAGNOSIS APPARATUS AND BATTERY DIAGNOSIS METHOD**

(30) Priority: 10.09.2024 KR 20240123467
(71) Applicant: LG Energy Solution, Ltd., Seoul 07335 (KR)
(72) Inventor: KIM, Tae Hyeon, Daejeon 34122 (KR); KIM, Young Deok, Daejeon 34122 (KR); CHOI, Hyun Jun, Daejeon 34122 (KR)
(74) Representative: Goddar, Heinz J.
(86) International application number: PCT/KR2025/011806
(87) International publication number: WO 2026/059103

(57) **Abstract**

According to an embodiment disclosed in this document, there is provided a battery diagnosis device including a memory configured to store battery data regarding a battery cell containing a plurality of active materials and at least one processor, in which the at least one processor is configured to identify a capacity of the battery cell, identify a reaction ratio of each of the plurality of active materials based on a voltage profile of each of the plurality of active materials, identify a degraded reaction capacity of each of the plurality of active materials based on the reaction ratio and the capacity of the battery cell, and identify a occupied by each of the plurality of active materials in a positive electrode capacity loss rate based on the reaction capacity and the positive electrode capacity loss rate.

## Description

### TECHNICAL FIELD

### Cross-reference to Related Applications

This application claims priority from Korean Patent Application No. 10-2024-0123467, filed on September 10, 2024, the disclosure of which is incorporated by reference herein.

### Technical Field

Embodiments disclosed in this document relate to a battery diagnosis device and a battery diagnosis method.

### BACKGROUND ART

When a positive electrode or negative electrode of a battery cell is composed of a single active material, voltage profiles of the positive electrode and negative electrode may be acquired from an entire voltage profile of the battery cell based on positive and negative electrode separation technology. However, when the positive electrode or negative electrode is a mixed electrode composed of a plurality of active materials, since the voltage profile includes electrochemical characteristics corresponding to the plurality of active materials, there is a limitation in that the degree of degradation of each of the plurality of active materials cannot be known.

### DISCLOSURE OF THE INVENTION

### TECHNICAL PROBLEM

Embodiments disclosed in this document provide a battery diagnosis device and a battery diagnosis method for diagnosing a degree of degradation of each of a plurality of active materials in a battery cell using the voltage profile of each of the plurality of active materials.

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery diagnosis device including a memory configured to store battery data regarding a battery cell containing a plurality of active materials and at least one processor, in which the at least one processor is configured to identify a capacity of the battery cell, identify a reaction ratio of each of the plurality of active materials based on a voltage profile of each of the plurality of active materials, identify a degraded reaction capacity of each of the plurality of active materials based on the reaction ratio and the capacity of the battery cell, and identify a proportion occupied by each of the plurality of active materials in a positive electrode capacity loss rate based on the reaction capacity and the positive electrode capacity loss rate.

For example, the at least one processor may be configured to identify the positive electrode capacity loss rate using the battery profile and the capacity of the battery cell in a BOL state.

For example, the at least one processor may be configured to identify the reaction ratio representing a ratio between the plurality of active materials contained in the battery cell, identify a positive electrode voltage profile of the battery cell based on the reaction ratio and the voltage profile of each of the plurality of active materials, and identify a reaction capacity representing a degraded capacity of each of the plurality of active materials using a reference positive electrode voltage profile and the positive electrode voltage profile.

For example, the battery data may include at least one of a total capacity of the battery cell in a BOL state, the capacity of each of the plurality of active materials in the BOL state, or any combination thereof.

For example, the plurality of active materials may include at least one of lithium manganese iron phosphate (LMFP), nickel, cobalt, manganese (NCM), silicon, graphite, or any combination thereof.

For example, the at least one processor may be configured to identify a degree of degradation of each of the plurality of active materials based on identifying the proportion occupied by each of the plurality of active materials.

For example, the at least one processor may be configured to identify a first active material exceeding a designated degree of degradation among the plurality of active materials based on identifying the degree of degradation of each of the plurality of active materials, and identify a voltage at which the first active material reacts based on identifying the first active material.

For example, the at least one processor may be configured to control a charging speed for the charging based on identifying the voltage at which the first active material reacts while charging the battery cell.

According to an embodiment disclosed in this document, there is provided a battery diagnosis method including an operation of identifying a capacity of a battery cell containing a plurality of active materials, an operation of identifying a reaction ratio of each of the plurality of active materials based on a voltage profile of each of the plurality of active, an operation of identifying a degraded reaction capacity of each of the plurality of active materials based on the reaction ratio and the capacity of the battery cell, and an operation of identifying a proportion occupied by each of the plurality of active materials in a positive electrode capacity loss rate based on the reaction capacity and the positive electrode capacity loss rate.

For example, the operation of identifying the proportion occupied by each of the plurality of active materials may include an operation of identifying the positive electrode capacity loss rate using the battery profile and the capacity of the battery cell in a BOL state.

For example, the operation of identifying the reaction capacity may include an operation of identifying the reaction ratio representing a ratio between the plurality of active materials contained in the battery cell, an operation of identifying a positive electrode voltage profile of the battery cell based on the reaction ratio and the voltage profile of each of the plurality of active materials, and an operation of identifying a reaction capacity representing a degraded capacity of each of the plurality of active materials using a reference positive electrode voltage profile and the positive electrode voltage profile.

For example, the battery data may include at least one of a total capacity of the battery cell in the BOL state, the capacity of each of the plurality of active materials in the BOL state, or any combination thereof.

For example, the plurality of active materials may include at least one of lithium manganese iron phosphate (LMFP), nickel, cobalt, manganese (NCM), silicon, graphite, or any combination thereof.

For example, the battery diagnosis method may further include an operation of identifying a degree of degradation of each of the plurality of active materials based on identifying the proportion occupied by each of the plurality of active materials.

For example, the operation of identifying the degree of degradation may include an operation of identifying a first active material exceeding a designated degree of degradation among the plurality of active materials based on identifying the degree of degradation of each of the plurality of active materials, and an operation of identifying a voltage at which the first active material reacts based on identifying the first active material.

### ADVANTAGEOUS EFFECTS

The battery diagnosis device and battery diagnosis method according to the embodiments disclosed in this document can diagnose the degree of degradation of each of the plurality of active materials in the battery cell using the voltage profile of each of the active materials.

In addition, various effects that are directly or indirectly identified through this document can be provided.

### BRIEF DESCRIPTION OF THE DRAWINGS

FIG. 1 is a block diagram showing a battery pack according to an embodiment disclosed in this document.
FIG. 2 is a block diagram illustrating the configuration of a battery diagnosis device according to an embodiment disclosed in this document.
FIGS. 3a to 3c illustrate examples of voltage profiles related to a battery cell according to an embodiment disclosed in this document.
FIG. 4 illustrates an example of a graph representing data related to a battery cell according to an embodiment disclosed in this document.
FIG. 5 illustrates an example of a table representing data related to a battery cell according to an embodiment disclosed in this document.
FIG. 6 shows an example of a flowchart illustrating an operation performed by a battery diagnosis device according to an embodiment disclosed in this document.
FIG. 7 illustrates a computing system executing a battery diagnosis method according to an embodiment disclosed in this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

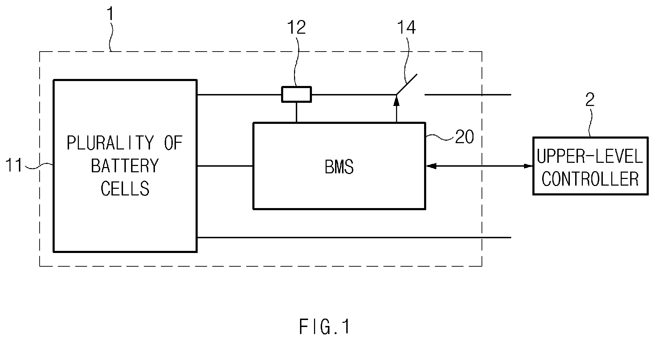

FIG. 1 is a block diagram showing a battery pack according to an embodiment disclosed in this document.

Referring to FIG. 1, a battery control system including a battery pack 1 and an upper-level controller 2 included in an upper-level system according to an embodiment disclosed in this document is schematically illustrated.

As illustrated in FIG. 1, the battery pack 1 may include a plurality of battery cells 11, a switching unit 14 connected in series to a first terminal side and/or a second terminal side of the plurality of battery cells 11 to control a charge and/or discharge current flow of the plurality of battery cells 11, and a battery management system 20 that monitors the voltage, current, temperature, etc. of the battery pack 1 to prevent overcharging and overdischarging.

In this case, the battery pack 1 may be equipped with a plurality of the plurality of cells 11, sensors 12, switching units 14, and battery management systems 20. For example, a first terminal may be a positive (+) terminal of the plurality of battery cells 11, and a second terminal may be a negative (-) terminal thereof.

Here, the switching unit 14 is a device for controlling the current flow for charging or discharging the plurality of battery cells 11, and for example, at least one relay, magnetic contactor, etc. may be used depending on the specifications of the battery pack 1.

For example, the plurality of battery cells 11 may include a cylindrical battery. The cylindrical battery may refer to a battery in which battery materials are packaged in a cylindrical shape. Since the plurality of battery cells 11 include cylindrical batteries, if lithium deposition occurs inside the cylindrical batteries during constant voltage charging of the plurality of battery cells 11, a phenomenon in which the current flowing through the plurality of battery cells 11 increases may occur.

The battery management system 20 is an interface that receives values obtained by measuring various parameters described above, and may include a plurality of terminals, a circuit connected to these terminals and performs processing of the received values, etc. In addition, the battery management system 20 may control the ON/OFF of the switching unit 14, for example, a relay or a contactor, and may be connected to the battery cell 11 to monitor the state of each of the plurality of battery cells 11.

The upper-level controller 2 may transmit a control signal for the plurality of battery cells 11 to the battery management system 20. Accordingly, the operation of the battery management system 20 may be controlled based on a signal applied from the upper-level controller 2.

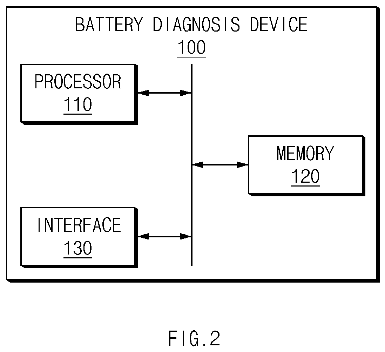

According to the embodiment, the battery management system 20 may include a battery diagnosis device 100 of FIG. 2. According to another embodiment, the battery management system 20 may be another system different from the battery diagnosis device 100 of FIG. 2. That is, the battery diagnosis device 100 of FIG. 2 may be included in the battery pack 1 or may be configured as another device external to the battery pack 1. For convenience of description, it will be described on the premise that the battery diagnosis device 100 is configured as another device external to the battery pack 1.

FIG. 2 is a block diagram illustrating the configuration of a battery diagnosis device according to an embodiment disclosed in this document.

The battery diagnosis device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may mean a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto. Some of the pieces of hardware of FIG. 1 (e.g., at least a portion of the processor 110, memory 120, and communication circuit (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery diagnosis device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

Hereinafter, the operation of the battery diagnosis device 100 (or the processor 110) may be performed by a battery management system (BMS) in a vehicle, and may also be performed in various devices such as a server, cloud, charger, or charger/discharger.

The memory 120 of the battery diagnosis device 100 according to an embodiment may include hardware components for storing data and/or instructions input and/or output to and from the processor 110. The memory 120 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC).

For example, the memory 120 may be configured to store battery data regarding a battery cell (e.g., at least one of one or more battery cells 11 of FIG. 1) containing a plurality of active materials.

For example, the plurality of active materials may include materials that constitute a positive electrode of the battery cell or a negative electrode of the battery cell. For example, the positive electrode of the battery cell or the negative electrode of the battery cell may include a mixed electrode containing one or more active materials.

For example, the plurality of active materials may include at least one of lithium manganese iron phosphate (LMFP), nickel, cobalt, manganese (NCM), silicon, graphite, or any combination thereof.

In an embodiment, the battery data may include at least one of the total capacity of the battery cell in a BOL state, the capacity of each of the plurality of active materials in the BOL state, or any combination thereof.

For example, the battery data may include a voltage profile of each of the plurality of active materials and/or a voltage profile of the battery cell. The voltage profile may represent a voltage relative to a capacity. The voltage profile may represent a voltage change with respect to a capacity change.

The interface 130 of the battery diagnosis device 100 according to an embodiment may be configured to generate various battery measurement values from the battery. To this end, the interface 130 may include measuring means such as a voltmeter, ammeter, thermometer, etc., and a communication circuit for establishing a communication link with an external device. As an example, the interface 130 may include a temperature sensor attached to the battery cell. For example, the interface 130 may be configured to acquire a voltage profile representing a relationship between the voltage of a battery cell and the capacity of the battery cell.

The processor 110 according to an embodiment may identify the voltage profile of each of the plurality of active materials. The processor 110 may identify a reaction ratio of each of the plurality of active materials based on the voltage profile of each of the plurality of active materials.

In an embodiment, the processor 110 may identify the reaction ratio representing a ratio between the plurality of active materials contained in the battery cell. For example, the processor 110 may identify the reaction ratio of each of the plurality of active materials by comparing a reference voltage profile of the positive electrode within the battery cell with a positive electrode voltage profile. For example, the reaction ratio may represent the proportion of each of the plurality of active materials contained in the positive electrode within the battery cell.

For example, the processor 110 may identify the reference voltage profile of the positive electrode within the battery cell. For example, the processor 110 may identify the positive electrode voltage profile of the battery cell based on the reaction ratio and the voltage profile of each of the plurality of active materials.

For example, the processor 110 may acquire the positive electrode voltage profile that simulates the reference voltage profile of the positive electrode within the battery cell by synthesizing the voltage profiles of the plurality of active materials. For example, the processor 110 may acquire the positive electrode voltage profile by shrinking or expanding the voltage profile of each of the plurality of active materials while the shape of the voltage profile of each of the plurality of active materials is maintained.

For example, since the voltage at which the active material reacts is different for each active material, the processor 110 may determine the reaction ratio of each of the plurality of active materials by mapping the synthesized positive electrode voltage profile to the reference voltage profile by shrinking or expanding the voltage profile of each of the plurality of active materials.

In an embodiment, the processor 110 may identify a degraded reaction capacity of each of the plurality of active materials using the reference positive electrode voltage profile and the positive electrode voltage profile. The processor 110 according to an embodiment may identify the reaction capacity, which represents the degraded capacity of each of the plurality of active materials, based on the reaction ratio and the capacity of the battery cell. The capacity of the battery cell may include the capacity of each of the plurality of active materials.

The processor 110 according to an embodiment may identify the proportion occupied by each of the plurality of active materials in the positive electrode capacity loss rate based on the reaction capacity and the positive electrode capacity loss rate. The proportion occupied by each of the plurality of active materials in the positive electrode capacity loss rate may include a ratio indicating the degree to which each of the plurality of active materials has degraded. The proportion occupied by each of the plurality of active materials in the positive electrode capacity loss rate may mean the proportion within the positive electrode degradation.

For example, the processor 110 may identify the positive electrode capacity loss rate using the battery profile and the capacity of the battery cell in the BOL state.

For example, the battery profile in the BOL state may include the capacity of each of a plurality of active materials in the BOL state.

For example, the processor 110 may identify a degradation ratio indicating the degree to which a battery cell has degraded relative to a battery cell in a BOL state by using the ratio of the reaction capacity of each of the plurality of active materials to the capacity of each of the plurality of active materials in the BOL state.

For example, the processor 110 may identify the proportion occupied by each of the plurality of active materials in the positive electrode capacity loss by using the degradation ratio and the positive electrode capacity loss rate.

The processor 110 according to an embodiment may identify the degree of degradation of each of the plurality of active materials based on identifying the proportion occupied by each of the plurality of active materials.

In an embodiment, the processor 110 may identify a first active material among the plurality of active materials that exceeds a designated degree of based on identifying the degree of degradation of each of the plurality of active materials. The processor 110 may identify the voltage at which the first active material reacts based on identifying the first active material.

In an embodiment, the processor 110 may control the charging speed for charging based on identifying the voltage at which the first active material reacts while the battery cell is charged. For example, the processor 110 may reduce the charging speed to slow down the degradation of the first active material, but is not limited thereto.

The battery diagnosis device 100 according to an embodiment as described above may quantify the degree of degradation of each of the plurality of active materials contained in at least one electrode of the battery cell by using the voltage profile of each of the plurality of active materials. The battery diagnosis device 100 may control the charging speed of the battery cell at a voltage at which at least one active material, which exceeds a designated degree of degradation, among a plurality of active materials reacts. The battery diagnosis device 100 may control the degradation of a specific material contained in the battery cell by controlling the charging speed of the battery cell at a voltage at which at least one active material reacts.

For example, the battery diagnosis device 100 may control the degradation of a specific material by using the voltage profile of each of the plurality of active materials as well as the voltage profile of the same active material in the battery cell. For example, when the voltage profiles are different depending on the particle size, etc., within the same active material, the battery diagnosis device 100 may control the degradation of the specific material by using different voltage profiles.

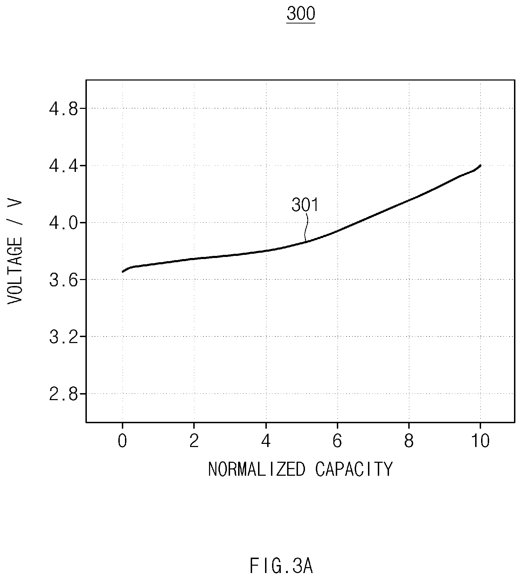

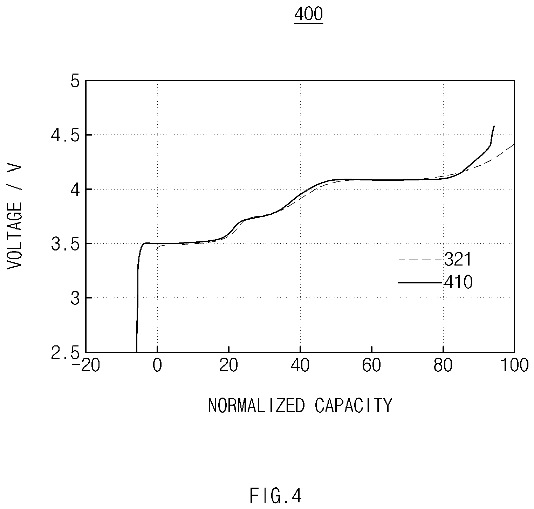

FIGS. 3a to 3c illustrate examples of voltage profiles related to a battery cell according to an embodiment disclosed in this document. FIG. 4 illustrates an example of a graph representing data related to a battery cell according to an embodiment disclosed in this document. The battery diagnosis device of FIGS. 3a to 3c and FIG. 4 may be referenced to the battery diagnosis device 100 of FIG. 2.

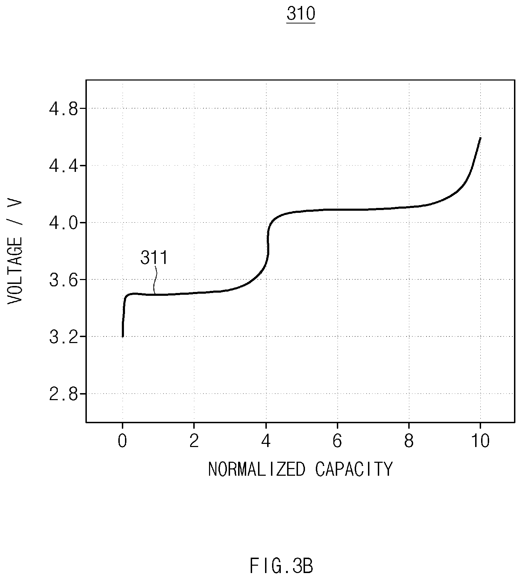

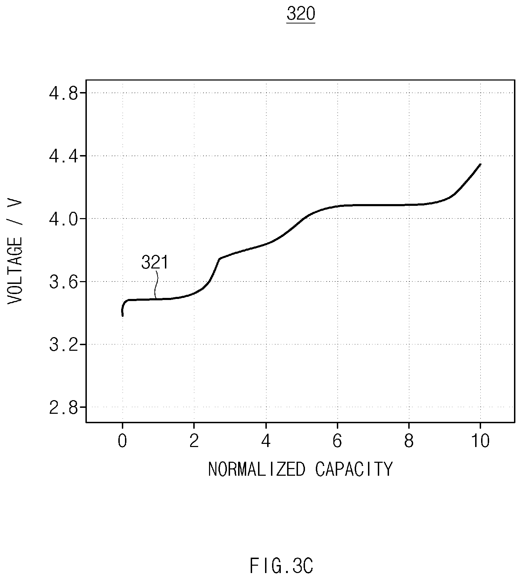

FIG. 3a illustrates an example of a graph 300 representing a first voltage profile 301 of a first active material among a plurality of active materials contained in a positive electrode within a battery cell. FIG. 3b illustrates an example of a graph 310 representing a second voltage profile 311 of a second active material among a plurality of active materials contained in the positive electrode within the battery cell. FIG. 3c illustrates an example of a graph 320 representing a reference positive electrode voltage profile 321 of a positive electrode of a battery cell. FIG. 4 illustrates an example of a graph 400 including a reference positive electrode voltage profile 321 and a positive electrode voltage profile 410 of a battery cell. For example, the positive electrode of the battery cell may contain a first active material and a second active material.

Referring to the graph 300 and graph 310, it can be seen that the shapes of the first voltage profile 301 and the second voltage profile 311 are different because the voltages at which the first and second cargoes react are different. The battery diagnosis device 100 may generate a positive electrode voltage profile mapped to the reference positive electrode voltage profile 321 by using the voltage difference at which the first active material and the second active material react.

Referring to FIG. 4, the battery diagnosis device 100 according to an embodiment may acquire a positive electrode voltage profile 410 obtained by synthesizing the first voltage profile 301 and the second voltage profile 311. The battery diagnosis device 100 may determine a reaction ratio between the first active material and the second active material contained within the positive electrode by mapping the positive electrode voltage profile 410 and the reference voltage profile 321. However, it is not limited thereto. For example, the battery diagnosis device 100 may determine the reaction ratio of each active material by using a reference negative electrode voltage profile of a negative electrode and the voltage profile of each of active materials contained in the negative electrode.

As described above, the battery diagnosis device 100 according to an embodiment may identify the reaction ratio of the battery cell in the BOL state after manufacturing the battery cell and compare the reaction ratio of the battery cell in the BOL state with a preset reaction ratio to check whether the battery cell has been manufactured correctly.

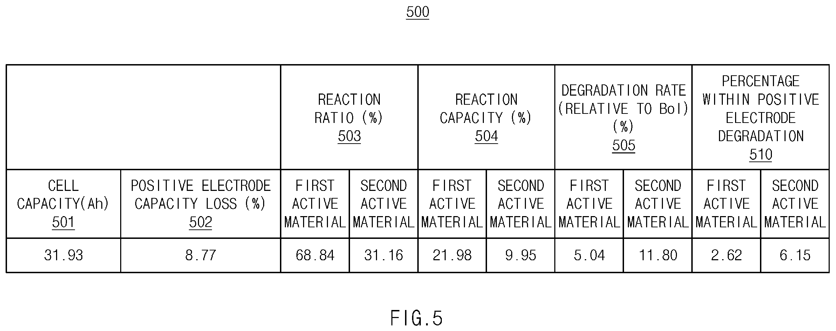

FIG. 5 illustrates an example of a table representing data related to a battery cell according to an embodiment disclosed in this document. The battery diagnosis device 100 of FIG. 5 may be referenced to the battery diagnosis device 100 of FIG. 2.

Referring to FIG. 5, a table 500 may include data related to a battery cell. Data related to the positive electrode of the battery cell may include data indicating a capacity 501 of the battery cell, a positive electrode capacity loss 502, a reaction ratio 503 of each of the plurality of active materials, a reaction capacity 504 of each of the plurality of active materials, a degradation ratio 505 of each of the plurality of active materials, and/or a proportion 510 occupied by each of the plurality of active materials in the positive electrode capacity loss rate.

The battery diagnosis device 100 according to an embodiment may identify the reaction ratio 503 of each of the plurality of active materials. The battery diagnosis device 100 may acquire the reaction capacity 504 of each of the plurality of active materials based on the reaction ratio 503 and the capacity 501 (or the total capacity) of the battery cell.

For example, the battery diagnosis device 100 may identify the reaction capacity 504 by multiplying the reaction ratio 503 of each of the plurality of active materials by the capacity 501 of the battery cell. For example, the reaction capacity (e.g., 21.98) of the first active material may be acquired by multiplying the reaction ratio (e.g., 68.84%) of the first active material by the capacity (e.g., 31.93) of the battery cell.

The battery diagnosis device 100 according to an embodiment may identify the degradation ratio 505 using the battery profile and the reaction capacity 504 in the BOL state. For example, the battery profile in the BOL state may include the reactive capacity of the battery cell in the BOL state.

For example, when the reaction capacity in the BOL state for the first active material is identified, the battery diagnosis device 100 may determine the degradation ratio (e.g., 5.04%) of the first active material by subtracting the ratio (e.g., 21.98 Ah) of the reaction capacity of the first active material to the reaction capacity (e.g., approximately 23.15 Ah) in the BOL state from a first value (e.g., 100%).

The battery diagnosis device 100 according to an embodiment may identify the proportion 510 occupied by each of the plurality of active materials in the positive electrode capacity loss rate by using the degradation ratio 505 and the positive electrode capacity loss rate 502.

For example, a proportion (e.g., 2.62%) occupied by the first active material in the positive electrode capacity loss rate may be acquired by multiplying the degradation ratio (e.g., 5.04%) of the first active material with respect to the total degradation ratio (e.g., the sum of the deterioration ratio of the first active material and the deterioration ratio of the second active material) by the positive electrode capacity loss rate (e.g., 8.77%) of the first active material.

The battery diagnosis device 100 according to an embodiment as described above may control the degradation of a specific material by quantifying the degree of degradation of each of the plurality of active materials within the battery cell.

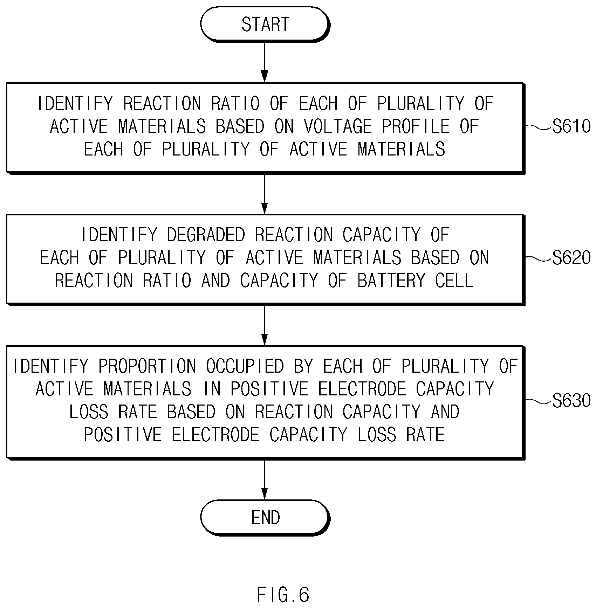

FIG. 6 illustrates an example of a flowchart showing operations performed by a battery diagnosis device according to an embodiment disclosed in this document.

FIG. 6 is a flowchart showing a battery diagnosis method according to an embodiment disclosed in this document. Hereinafter, it is assumed that the battery diagnosis device 100 of FIG. 2 performs the process of FIG. 6. In addition, the operations described as being performed by the device may be understood to be controlled by the processor 110 of the battery diagnosis device 100. Each of the operations in FIG. 6 may be performed sequentially, but is not necessarily performed sequentially. For example, the order of each of the operations may be changed, and at least two operations may be performed in parallel.

In operation S610, the battery diagnosis device according to an embodiment may identify the reaction ratio of each of the plurality of active materials based on the voltage profile of each of the plurality of active materials.

For example, the battery diagnosis device may acquire the voltage profile (e.g., the first voltage profile 301 of FIG. 3a and/or the second voltage profile 311 of FIG. 3b) of each of a plurality of active materials through an interface (e.g., the interface 130 of FIG. 2).

For example, the battery diagnosis device may acquire the reaction ratio (e.g., the reaction ratio 503 of FIG. 5) of each of the plurality of active materials by mapping the positive electrode voltage profile (e.g., the positive electrode voltage profile 410 of FIG. 4), which is obtained by merging the voltage profiles of each of the plurality of active materials, to a reference voltage profile (e.g., the reference voltage profile 321 of FIG. 3c).

In operation S620, the battery diagnosis device according to an embodiment may identify the degraded reaction capacity of each of the plurality of active materials based on the reaction ratio and the capacity of the battery cell.

For example, the battery diagnosis device may identify the reaction capacity (e.g., the reaction capacity 504 of FIG. 5) by multiplying the reaction ratio by the capacity (e.g., the capacity 501 of FIG. 5) of the battery cell.

For example, the battery diagnosis device may acquire a degradation ratio (e.g., the degradation ratio 505 of FIG. 5) based on the identified reaction capacity and the reaction capacity of the battery cell in the BOL state.

In operation S630, the battery diagnosis device according to an embodiment may identify the proportion occupied by each of the plurality of active materials in the positive electrode capacity loss rate based on the reaction capacity and the positive electrode capacity loss rate.

For example, the battery diagnosis device may identify the ratio the proportion (e.g., the ratio 510 of FIG. 5) occupied by of each of the plurality of active materials by using the degradation ratio acquired using the reaction capacity and the positive electrode capacity loss rate (e.g., the positive electrode capacity loss rate 502 of FIG. 5).

In an embodiment, the battery diagnosis device may identify the degree of degradation of each of the plurality of active materials based on identifying the proportion occupied by each of the plurality of active materials.

In an embodiment, the battery diagnosis device may identify the first active material among the plurality of active materials that exceeds a designated degree of degradation based on identifying the degree of degradation for each of the plurality of active materials.

In an embodiment, the battery diagnosis device may identify a voltage at which the first active material reacts based on identifying the first active material.

The battery diagnosis device according to an embodiment may control the charging speed at the voltage at which the first active material reacts while the battery cell is charged, based on identifying the voltage at which the first active material reacts.

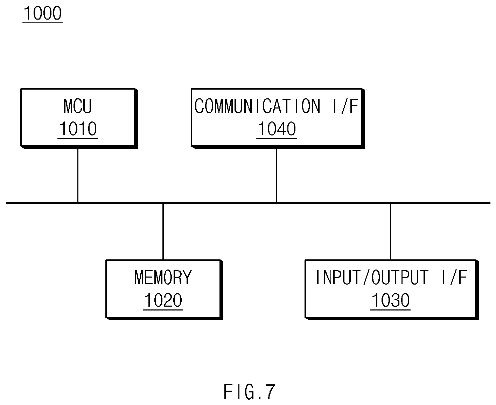

FIG. 7 illustrates a computing system executing a battery diagnosis method according to an embodiment disclosed in this document.

Referring to FIG. 7, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020 (e.g., an SOH calculation program, a cell balancing target determination program, etc.), processes various data including the state of charge (SOC), state of health (SOH), etc. of a plurality of battery cells through these programs, and performs the functions of the battery diagnosis device 100 described with reference to FIGS. 2 to 6. The MCU 1010 may be, but is not limited to, a BMS, a separate PC, or the cloud.

The memory 1020 may store various programs related to calculating the SOH of battery cells and determining the target for cell balancing. Furthermore, the memory 1020 may store various data, such as SOC data and SOH data for each battery cell.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, a program or various data for calculating the SOH of a battery cell or determining a balancing target may be transmitted to and received from a separately provided external server through the communication I/F 1040.

In this way, the battery diagnosis method according to an embodiment disclosed in this document may be recorded in the memory 1020 and executed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery diagnosis device comprising:
a memory configured to store battery data regarding a battery cell containing a plurality of active materials; and
at least one processor,
wherein the at least one processor is configured to:
identify a capacity of the battery cell;
identify a reaction ratio of each of the plurality of active materials based on a voltage profile of each of the plurality of active materials;
identify a degraded reaction capacity of each of the plurality of active materials based on the reaction ratio and the capacity of the battery cell; and
identify a proportion occupied by each of the plurality of active materials in a positive electrode capacity loss rate based on the reaction capacity and the positive electrode capacity loss rate.

2. The battery diagnosis device of claim 1, wherein the at least one processor is configured to identify the positive electrode capacity loss rate using the battery profile and the capacity of the battery cell in a BOL state.

3. The battery diagnosis device of claim 2, wherein the at least one processor is configured to:
identify the reaction ratio representing a ratio between the plurality of active materials contained in the battery cell;
identify a positive electrode voltage profile of the battery cell based on the reaction ratio and the voltage profile of each of the plurality of active materials; and
identify a reaction capacity representing a degraded capacity of each of the plurality of active materials using a reference positive electrode voltage profile and the positive electrode voltage profile.

4. The battery diagnosis device of claim 1, wherein the battery data includes at least one of a total capacity of the battery cell in a BOL state, the capacity of each of the plurality of active materials in the BOL state, or any combination thereof.

5. The battery diagnosis device of claim 1, wherein the plurality of active materials includes at least one of lithium manganese iron phosphate (LMFP), nickel, cobalt, manganese (NCM), silicon, graphite, or any combination thereof.

6. The battery diagnosis device of claim 1, wherein the at least one processor is configured to identify a degree of degradation of each of the plurality of active materials based on identifying the proportion occupied by each of the plurality of active materials.

7. The battery diagnosis device of claim 6, wherein the at least one processor is configured to:
identify a first active exceeding a designated degree of degradation among the plurality of active materials based on identifying the degree of degradation of each of the plurality of active materials; and
identify a voltage at which the first active material reacts based on identifying the first active material.

8. The battery diagnosis device of claim 7, wherein the at least one processor is configured to control a charging speed for the charging based on identifying the voltage at which the first active material reacts while charging the battery cell.

9. A battery diagnosis method comprising:
an operation of identifying a capacity of a battery cell containing a plurality of active materials;
an operation of identifying a reaction ratio of each of the plurality of active materials based on a voltage profile of each of the plurality of active;
an operation of identifying a degraded reaction capacity of each of the plurality of active materials based on the reaction ratio and the capacity of the battery cell; and
an operation of identifying a proportion occupied by each of the plurality of active materials in a positive electrode capacity loss rate based on the reaction capacity and the positive electrode capacity loss rate.

10. The battery diagnosis method of claim 9, wherein the operation of identifying the proportion occupied by each of the plurality of active materials includes an operation of identifying the positive electrode capacity loss rate using the battery profile and the capacity of the battery cell in a BOL state.

11. The battery diagnosis method of claim 10, wherein the operation of identifying the reaction capacity includes:
an operation of identifying the reaction ratio representing a ratio between the plurality of active materials contained in the battery cell;
an operation of identifying a positive electrode voltage profile of the battery cell based on the reaction ratio and the voltage profile of each of the plurality of active materials; and
an operation of identifying a reaction capacity representing a degraded capacity of each of the plurality of active materials using a reference positive electrode voltage profile and the positive electrode voltage profile.

12. The battery diagnosis method of claim 10, wherein the battery data includes at least one of a total capacity of the battery cell in the BOL state, the capacity of each of the plurality of active materials in the BOL state, or any combination thereof.

13. The battery diagnosis method of claim 9, wherein the plurality of active materials includes at least one of lithium manganese iron phosphate (LMFP), nickel, cobalt, manganese (NCM), silicon, graphite, or any combination thereof.

14. The battery diagnosis method of claim 9, further comprising:
an operation of identifying a degree of degradation of each of the plurality of active materials based on identifying the proportion occupied by each of the plurality of active materials.

15. The battery diagnosis method of claim 14, wherein the operation of identifying the degree of degradation includes:
an operation of identifying a first active material exceeding a designated degree of degradation among the plurality of active materials based on identifying the degree of degradation of each of the plurality of active materials; and
an operation of identifying a voltage at which the first active material reacts based on identifying the first active material.
